Europäisches Patentamt

European Patent Office

Office européen des brevets

(19)

(11) Veröffentlichungsnummer: **0 101 752**
**B1**

(12) **EUROPÄISCHE PATENTSCHRIFT**

(45) Veröffentlichungstag der Patentschrift:
27.08.86

(51) Int. Cl.⁴: **G 03 F 7/00, H 01 L 21/308**

(21) Anmeldenummer: **82107797.1**

(22) Anmeldetag: **25.08.82**

(54) Umkehrprozess zum Herstellen von Chrommasken.

(43) Veröffentlichungstag der Anmeldung:
07.03.84 Patentblatt 84/10

(45) Bekanntmachung des Hinweises auf die Patenterteilung:
27.08.86 Patentblatt 86/35

(84) Benannte Vertragsstaaten:
DE FR GB IT

(56) Entgegenhaltungen:
US - A - 3 795 557
US - A - 4 132 586

(73) Patentinhaber: **IBM DEUTSCHLAND GMBH,**
**Pascalstrasse 100, D-7000 Stuttgart 80 (DE)**

(84) Benannte Vertragsstaaten: **DE**

(73) Patentinhaber: **International Business Machines**
**Corporation, Old Orchard Road, Armonk, N.Y. 10504 (US)**

(84) Benannte Vertragsstaaten: **FR GB IT**

(72) Erfinder: **Bock, Günter, Ernst-Reuter-Strasse 28,**
**D-7030 Böblingen (DE)**
Erfinder: **Hafner, Bernhard, Pirolweg 3,**
**D-7031 Unterjettingen (DE)**
Erfinder: **Mühl, Reinhold, Grabenstrasse 29B,**
**D-7031 Gärtringen (DE)**
Erfinder: **Thiel, Klaus Peter, Einsteinstrasse 35,**
**D-6108 Weiterstadt (DE)**

(74) Vertreter: **Oechssler, Dietrich, Dr. rer. nat., Schönaicher**
**Strasse 220, D-7030 Böblingen (DE)**

## Beschreibung

Die Erfindung betrifft einen Umkehrprozess zum Herstellen von Chrommasken, bei dem auf ein mit einer Chromschicht beschichtetes transparentes Substrat eine Schicht aus Positivphotolack, im folgenden Positivlack genannt, aufgebracht, anschliessend durch eine Belichtungsmaske belichtet, entwickelt und ganzflächig mit einer Schicht aus einem Material, welches langsamer als Chrom trockengeätzt wird, beschichtet wird, bei dem dann die Photolackschicht und das auf ihr liegende Material abgehoben und schliesslich das Chrom trockengeätzt wird, wobei das noch vorhandene Material als Ätzmaske dient.

Unter einem Umkehrprozess wird ein Prozess verstanden, mit dem auf photolithographischem Weg das Negativ des Musters von Öffnungen in einer Belichtungsmaske aus einer Schicht, welche beispielsweise aus Chrom besteht, herausgeätzt wird. Chrommasken werden beispielsweise in der Halbleitertechnik verwendet, um Metallisierungsmuster oder Muster von Diffusionsfenstern photolithographisch auf Halbleitersubstrate zu übertragen.

Umkehrprozesse sind zum Beispiel dann wichtig, wenn von einem Maskenmuster aus irgendeinem Grund das Negativ und das Positiv benötigt wird. Dies ist dann erforderlich, wenn die Möglichkeit bestehen muss, ein Metallisierungsmuster sowohl mittels eines Additiv- als auch mittels eines Subtraktiv-Prozesses herzustellen. Ein Umkehrprozess hat auch dann Bedeutung, wenn es ökonomischer ist, statt des Positivs das Negativ eines Maskenmusters herzustellen. Ein Beispiel soll dies veranschaulichen: Moderne Masken werden üblicherweise mit einem Mustergenerator erzeugt, mit dem ein programmgesteuerter Belichtungsstrahl eine auf dem Maskenmaterial aufgebrachte Photolackschicht an den Stellen belichtet, an welchen der Photolack und anschliessend in einem Ätzprozess das Maskenmaterial entfernt werden soll. Ist das zu erzeugende Maskenmuster von der Art, dass die Gesamtfläche der Maskenöffnungen mehr als 50% der Gesamtmaskenfläche ausmacht, so wird Zeit gespart, wenn nicht das gewünschte Muster von Öffnungen sondern sein Negativ mittels des Mustergenerators erzeugt wird und beim Einsatz der Maske die Übertragung des gewünschten Musters mittels eines Umkehrprozesses durchgeführt wird.

Gemäss dem Stand der Technik werden Umkehrprozesse insbesondere so durchgeführt, dass entweder durch Umkopieren unter Verwendung von Photoemulsionsplatten aus einer Maske, welche das Negativ des gewünschten Maskenmusters wiedergibt, eine Maske erzeugt wird, welche das gewünschte Maskenmuster wiedergibt, oder indem die Masken, welche das Negativ des gewünschten Maskenmusters wiedergeben in Verbindung mit Negativphotolacken, im folgenden Negativlack genannt, verwendet werden. Das Umkopieren hat den Nachteil, dass es apparativ und materialmässig sehr aufwendig ist und dass die Gefahr besteht, dass durch nicht völlig auszuschliessende Schmutzpartikel, entweder indem die Emulsionsschicht beschädigt wird oder indem die Partikel bei der Belichtung maskierend wirken, dass das zu erzeugende Muster verfälscht wird. Sowohl beim Umkopieren als auch bei der Verwendung von Negativlacken sind Dimensionsänderungen und Kantenunschärfen unvermeidlich. Darauf ist zurückzuführen, dass sowohl mit dem Umkopieren als auch bei der Verwendung von Negativlack eine Übertragung von sehr kleinen Musterelementen – die untere Grenze der Dimensionen, die dabei noch übertragen werden können, liegt bei ungefähr 2 µm – in einem fabrikmässigen Verfahren nicht mehr möglich ist (bei Positivlacken ist die erzielbare Auflösung nur durch die verwendete Strahlung und apparativ begrenzt).

Dies bedeutet mit anderen Worten, dass die genannten Verfahren mit dem zunehmenden Trend zu immer höheren Packungsdichten und kleineren Abmessungen immer ungeeigneter werden. Negativlacke haben gegenüber Positivlacken den weiteren Nachteil, dass die ersteren wegen ihrer Sauerstoffempfindlichkeit nur kurzzeitig lagerfähig sind.

In der US-Patentschrift 4 132 586 ist ein Prozess beschrieben, mit welchem eine Kontrastumkehr erzeugt werden kann, ohne dass dabei ein Umkopieren der Belichtungsmaske oder die Verwendung von Negativlacken erforderlich ist. Bei diesem Verfahren wird auf ein Substrat, welches mit einer Metallschicht, welches beispielsweise aus Chrom besteht, eine Positivlackschicht aufgebracht, durch eine Belichtungsmaske, welche ein Muster von Öffnungen aufweist, welche dem Negativ des Musters entspricht, welches in die Metallschicht geätzt werden soll, belichtet, entwickelt und ganzflächig mit einer Schicht aus Magnesiumoxid beschichtet. Anschliessend wird der Photolack und das auf ihm liegende Magnesiumoxid abgehoben und schliesslich das Chrom mittels reaktiven Ionenätzens entfernt, wobei das noch vorhandene Magnesiumoxid als Ätzmaske dient. Das Magnesiumoxid hat eine Dicke von 200 nm. Obwohl bei dem in der US-Patentschrift beschriebenen Verfahren kein Umkopieren stattfindet und Negativlacke nicht eingesetzt werden, finden trotzdem – wegen der relativ grossen Schichtdicke der Magnesiumoxidmaskenschicht – Dimensionsänderungen bei der Musterübertragung statt und die Kantenschärfe ist nicht optimal. Deshalb genügt das in der US-Patentschrift beschriebene Verfahren nicht völlig den Anforderungen, welche an ein Verfahren zur Übertragung von sehr dicht gepackten Mustern mit zum Teil sehr kleinen Musterelementen gestellt werden. Es kommt hinzu, dass die Haftung der Magnesiumoxidschicht auf dem Metall zu wünschen übrig lässt.

Es ist die Aufgabe der Erfindung, einen einfachen und sicheren Umkehrprozess zur Herstellung von Chrommasken anzugeben, mit welchem Muster mit sehr guter Kantenschärfe und mit hoher Abbildungsgenauigkeit auch dann übertragen werden können, wenn die Musterelemente Abmessungen im Mikrometer- und im Submikrometerbereich aufweisen.

Diese Aufgabe wird mit einem Umkehrprozess der eingangs genannten Art mit den Merkmalen des kennzeichnenden Teils des Patentanspruchs 1 gelöst.

Der erfindungsgemässe Umkehrprozess ist anwendbar für die Herstellung von Chrommasken, deren Maskenmuster Strukturelemente aufweisen, deren kleinste Abmessungen im Bereich der optischen Auflösungsgrenze (ca. 0,5 µm) liegen. Das Verfahren ist ausserdem dadurch ausgezeichnet, dass die Dichte der erzeugten Defekte ausserordentlich gering ist. Es kommt hinzu, dass das Siliciumdioxid überraschenderweise ganz ausgezeichnet auf dem Chrom haftet und dass auch sehr dünne $SiO_2$-Schichten ausgezeichnete Ätzmaskeneigenschaften haben. Aus den genannten Gründen ist der erfindungsgemässe Umkehrprozess sehr gut für die Übertragung von Maskenmustern, welche bei der Herstellung von dichtgepackten, hochintegrierten Halbleiterschaltungen eingesetzt werden, geeignet.

In vorteilhafter Weise wird das Chrom mittels Plasmaätzens geätzt. Es ist dabei günstig in einer Atmosphäre zu arbeiten, welche Sauerstoff und chlorierte Kohlenwasserstoffe im Volumenverhältnis 1:1 enthält. Unter diesen Bedingungen ist die Ätzrate des Siliciumdioxids vernachlässigbar klein. Besteht der Anteil der chlorierten Kohlenwasserstoffe im Ätzmedium aus 90 Vol.-% Trichloräthylen und 10 Vol.-% Dichloräthylen so ist sogar überhaupt keine Abtragung von Siliciumdioxid feststellbar.

Weitere vorteilhafte Ausgestaltungen des erfindungsgemässen Umkehrprozesses sind in den Unteransprüchen angegeben.

Die Erfindung wird anhand von durch Zeichnungen erläuterten Ausführungsbeispielen beschrieben. Es zeigen:

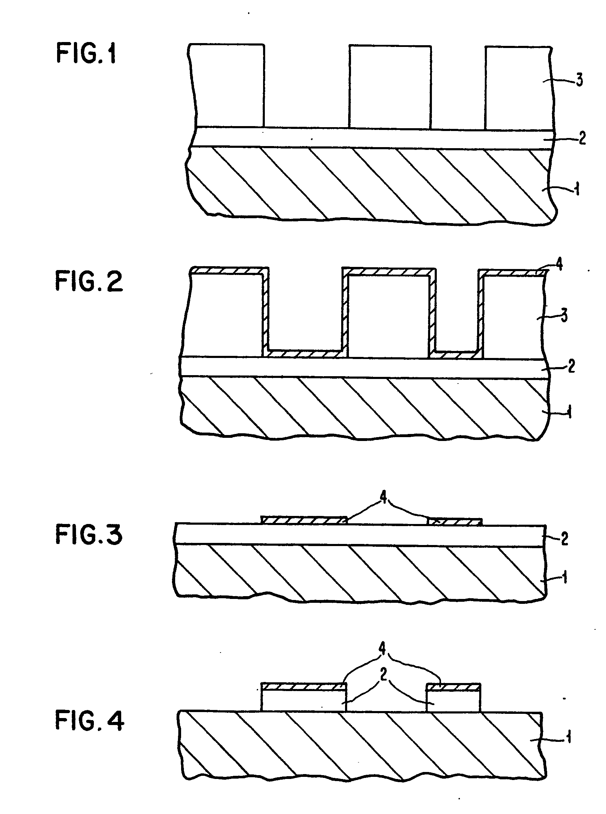

Fign. 1 bis 4 in schematischen Querschnittsdarstellungen die Herstellung der erfindungsgemässen Maske in verschiedenen Stadien der Herstellung.

Im folgenden soll anhand der Fign. 1 bis 4 die Herstellung der erfindungsgemässen Chrommaske beschrieben werden.

Die in der Fig. 1 im Querschnitt gezeigte Struktur ist aufgebaut aus einem Substrat 1, welches beispielsweise aus Natronkalkglas oder Quarzglas besteht, einer darauf aufgebrachten, grössenordnungsmässig 100 nm dicken Chromschicht 2 und einem darauf aufgebrachten Muster 3 aus einem positiven Photolack, welches das Negativ des gewünschten Maskenmusters wiedergibt. Das Photolackmuster 3 wird mittels konventioneller photolithographischer Verfahrensschritte erzeugt. Geeignete Positivlackmaterialien sind beispielsweise Phenol-Formaldehyd-Harze (Novolak) mit einem Diazonaphthochinon-Sensibilisator. Vorteilhafte Vertreter dieser Positivlackmaterialien sind die von der Fa. Shipley Co., Inc, Newton, Massachussetts, Vereinigte Staaten von Amerika unter den Handelsnamen AZ-1350 H, AZ-1350 J und AZ-1450 B vertriebenen Materialien.

Auf die in der Fig. 1 gezeigte Struktur wird ganzflächig eine ≤ 10 nm dicke Siliciumdioxidschicht 4 aufgebracht. Die dann vorliegende Struktur zeigt die Fig. 2 im Querschnitt. Die Siliciumdioxidschicht 4 kann mittels Kathodenzerstäubens oder mittels chemischen Niederschlagens aus der Gasphase aufgebracht werden. Die Siliciumdioxidschicht 4 haftet ausserordentlich gut auf der Chromschicht 2. Offenbar ist dies darauf zurückzuführen, dass sich unter den Bedingungen des Aufbringens eine nur wenige nm dicke Schichtstruktur ausbildet, welche aus einer auf der Chromschicht 2 aufliegenden Chromoxidschicht einer darüberliegenden Chrom und Silicium enthaltenden Oxidschicht und der obenliegenden Siliciumdioxidschicht besteht. Anschliessend wird das Photolackmuster 3 und die auf ihr liegenden Bereiche der Siliciumdioxidschicht 4 abgehoben. Dazu wird die Struktur in ein den Photolack lösendes Medium eingetaucht. Geeignete Medien sind eine bei 90 bis 100 °C angewandte Mischung, welche von der Fa. Indust-Ri-Chem. Laboratory, Richardson, Texas unter dem Handelsnamen J-100 vertrieben wird, und Caro'sche Säure, welche bei Zimmertemperatur eingesetzt wird. J-100 enthält 22,5 bis 23,9 Gew.-% nicht flüchtige Bestandteile, welche zum Teil aus dem Natriumsalz der Alkylnaphthalinsulfonsäure und der freien Alkylnaphthalinsulfonsäure bestehen. Der flüchtige Anteil der Mischung enthält 44,5 Gew.-% Tetrachloräthylen, 37 Gew.-% o-Dichlorbenzol, 0,8 Gew.-% p-Dichlorbenzol und 17,6 Gew.-% Phenol. Die J-100 Behandlung dauert ungefähr 40 Minuten. Günstige Ergebnisse werden mit Caro'scher Säure erzielt, welche beim Vereinigen von 1 l 96% Schwefelsäure und 45 ml 85% Wasserstoffperoxid entsteht. Die Behandlung mit dieser Caro'schen Säure dauert etwa 10 Min. Unter den angewandten Verfahrensbedingungen wird die Einwirkung des J-100 oder der Caro'schen Säure auf den Photolack durch die Quarzschicht 4 nicht wesentlich behindert. In der in der Fig. 3 gezeigten Struktur ist die Siliciumdioxidschicht 4 entsprechend dem gewünschten Maskenmuster ausgebildet.

Im folgenden Verfahrensschritt wird die Chromschicht 2 mittels Plasmaätzens selektiv entfernt, wobei die Siliciumdioxidschicht 4 als Ätzmaske dient. Zum Plasmaätzen ist eine Apparatur geeignet, wie sie beispielsweise in dem US-Patent 3 795 557 beschrieben ist. Bei der genannten Plasmaätzvorrichtung befinden sich die zu ätzenden Teile in einem liegenden, zylindrischen Gefäss, welches mit einem Deckel gasdicht verschliessbar ist und welches mindestens einen Gaseinlass für die reaktiven Gase und einen an eine Vakuumpumpe angeschlossenen Gasauslass aufweist. Auf die Aussenfläche des zylindrischen Gefässes ist eine mit einem HF-Generator verbundene Spule gewickelt, durch welche die notwendige Energie, um in dem Reaktionsgefäss ein Plasma aufrechtzuerhalten, zugeführt wird. Als Reaktionsgas werden eine Mischung aus Sauerstoff und chlorierten Kohlenwasserstoffen, vorzugsweise einem Gemisch aus 90 Vol.-% $C_2HCl_3$ und 10 Vol.-% $C_2H_2Cl_2$, verwendet. Zum Ätzen der grössenordnungsmässig 100 nm dicken Chromschicht 2 werden ungefähr 20 Minuten benötigt. Das Siliciumdioxid wird unter den genannten Reaktionsbedingungen praktisch überhaupt nicht angegriffen. Das Ergebnis des Plasmaätzens zeigt im Querschnitt die Fig. 4. Das Chrommuster 2 gibt das Negativ des in der Fig. 1 gezeigten Photolackmusters 3 wieder. Wegen der geringen Dicke der Siliciumdioxidschicht 4 ist es möglich, das Negativ des in der Fig. 1 gezeigten Photolackmusters 3 mit höchster Abbildungsgenauigkeit und einer sehr guten Kantenschärfe in die Chromschicht 2 zu übertragen. Die auf dem Chrommuster 2 verbliebene Siliciumdioxidschicht 4 kann dort verbleiben und als Schutz gegen mechanische Beschädigungen des Chroms dienen.

Im folgenden soll anhand eines Ausführungsbeispiels die Herstellung der erfindungsgemässen Maske noch detaillierter beschrieben werden.

Ausgegangen wird von einer Platte aus Natronkalkglas, welche mit einer durchgehenden, ungefähr 100 nm dicken Chromschicht bedeckt ist. Auf die Chromschicht wird eine ungefähr 400 nm dicke Schicht aus AZ-1350 H aufgeschleudert. Es folgen dann die üblichen photolithographischen Verfahrensschritte, d.h. das Trocknen und Vorerhitzen der Photolackschicht, das Belichten mittels einer Quecksilberhochdrucklampe durch eine Maske hindurch, welche ein Maskenmuster aufweist, welches dem Negativ des gewünschten Musters in der Chromschicht entspricht, und das Entwickeln der Photolackschicht in einer wässrigen KOH-Lösung. Ohne eine nachfolgende Wärmebehandlung wird die mit dem Photolackmuster bedeckte chrombeschichtete Glasplatte anschliessend in eine Kathodenzerstäubungsvorrichtung gebracht. Bei dieser Vorrichtung handelt es sich um eine konventionelle Kathodenzerstäubungsvorrichtung, welche zwei horizontal angeordnete, ebene, zueinander parallele Elektrodenplatten aufweist, wobei die untere Elektrode für die Aufnahme der zu beschichtenden Substrate vorgesehen ist und die obere Elektrode auf ihrer der unteren Elektrode zugewandten Seite die aus Siliciumdioxid bestehende Auftreffplatte aufweist. Die verwendete Kathodenzerstäubungsanlage gehört zum Typ der direkt getriebenen Anodensysteme. Zu Beginn der Kathodenzerstäubung liegt der Druck in der Kathodenzerstäubungskammer unter $2 \times 10^{-2}$ µbar. Es wird dann Argon mit einer Durchflussmenge von $100 \pm 5$ ml/Min. durch die Kammer geleitet. Der Arbeitsdruck liegt bei ungefähr 30 µbar. Die Gesamthochfrequenzleistung (13 MHz) liegt bei 0,8 kW. Dabei liegt an der Kathode eine Spannung von 2800 V und an der Anode eine Vorspannung von 600 V. Das Siliciumdioxid wird unter den genannten Bedingungen mit einer Geschwindigkeit von ungefähr 0,2 nm/sec abgeschieden. D.h. es dauert zwischen 40 und 60 Sekunden, um auf der Struktur eine ungefähr 10 nm dicke Siliciumdioxidschicht aufzubringen. Im folgenden Verfahrensschritt wird der Photolack und die auf ihm liegende Siliciumdioxidschicht abgehoben, indem die gesamte Struktur in einem Behälter, welcher auf 90 bis 100 °C erhitztes J-100 enthält, behandelt wird. Anschliessend folgt eine intensive Reinigung mit einer wässrigen alkalischen Lösung und mit Wasser. Nach dem Trocknen wird die chrombeschichtete Glasplatte, welche entsprechend dem gewünschten Muster mit der aufgebrachten Quarzschicht bedeckt ist, in die Plasmaätzvorrichtung, bei welcher es sich um eine Vorrichtung handelt, welche von der LFE-Corp. Waltham, Mass., V. St. A. unter der Typenbezeichnung LFE-(PFS/PCrE/PDS)-501 vertrieben wird, gebracht. Der Druck in der Plasmaätzkammer wird auf einen Wert von ungefähr 0,33 mbar eingestellt. Geätzt wird mit einer Mischung aus chlorierten Kohlenwasserstoffen und Sauerstoff im Volumenverhältnis 1:1, wobei der Kohlenwasserstoffanteil zu 90 Vol.-% aus Trichloräthylen und zu 10 Vol.-% aus Dichloräthylen besteht. Die Gasdurchflussmenge beträgt 12,5 ml/Min. Es wird bei einer Hochfrequenz von 13,5 MHz mit einer Leistung von 350 Watt gearbeitet. Die Ätzzeit, um die ungefähr 100 nm dicke Chromschicht selektiv wegzuätzen, beträgt zwischen 18 und 20 Minuten. Mit dem angegebenen Maskenherstellungsverfahren wurden auch Musterelemente in der Maske, deren Dimensionen nahe der optischen Auflösungsgrenze (ca. 0,5 µm) liegen, einwandfrei in die Chromschicht übertragen. Die hergestellte Chrommaske hatte ausserdem eine ausgezeichnete Kantenschärfe.

**Patentansprüche**

1. Umkehrprozess zum Herstellen von Chrommasken, bei dem auf ein mit einer Chromschicht (2) beschichtetes Substrat (1) eine Schicht (3) aus Positivphotolack aufgebracht, durch eine Belichtungsmaske belichtet, entwickelt und ganzflächig mit einer Schicht (4) aus einem Material, welches langsamer als Chrom trockengeätzt wird, beschichtet wird, bei dem dann die Photolackschicht (3) und die auf ihm liegende Schicht (4) abgehoben und schliesslich die Chromschicht (2) trockengeätzt wird, wobei die noch vorhandene Schicht (4) als Ätzmaske dient, dadurch gekennzeichnet, dass als das genannte Material Siliciumdioxid verwendet wird und die Siliciumdioxidschicht (4) $\leqslant$ 10 nm dick gemacht wird.

2. Umkehrprozess nach Anspruch 1, dadurch gekennzeichnet, dass die Siliciumdioxidschicht (4) zwischen 5 und 10 nm dick gemacht wird.

3. Umkehrprozess nach Anspruch 1 oder 2, dadurch gekennzeichnet, dass die Siliciumdioxidschicht (4) mittels Kathodenzerstäubens oder chemischen Niederschlagens aus der Gasphase erzeugt wird.

4. Umkehrprozess nach Anspruch 3, dadurch gekennzeichnet, dass beim Kathodenzerstäuben in einer Argonatmosphäre gearbeitet wird.

5. Umkehrprozess nach Anspruch 4, dadurch gekennzeichnet, dass bei einem Arbeitsdruck von ungefähr 30 µbar, einer Gesamthochfrequenzleistung von 0,8 KW einer Kathodenspannung von 2800 V, einer Anodenvorspannung von 600 V, und einem Argonfluss von ungefähr 100 ml/min gearbeitet wird.

6. Umkehrprozess nach einem der Ansprüche 1 bis 5, dadurch gekennzeichnet, dass die Photolackschicht (3) und die auf ihr liegende Siliciumdioxidschicht (4) mittels einer Mischung, enthaltend 22,5 bis 23,9 Gew.-% nichtflüchtige Bestandteile, welche zum Teil aus dem Natriumsalz der Alkylnaphthalinsulfonsäure und der freien Alkylnaphthalinsulfonsäure bestehen, und flüchtige Bestandteile, bestehend aus 44,5 Gew.-% Tetrachloräthylen, 37 Gew.-% o-Dichlorbenzol, 0,8 Gew.-% p-Dichlorbenzol und 17,6 Gew.-% Phenol oder Caro'scher Säure abgehoben wird.

7. Umkehrprozess nach einem der Ansprüche 1 bis 6, dadurch gekennzeichnet, dass die Chromschicht (2) mittels Plasmaätzens geätzt wird.

8. Umkehrprozess nach Anspruch 7, dadurch gekennzeichnet, dass in einer Chlorkohlenwasserstoff und Sauerstoff enthaltenden Atmosphäre geätzt wird.

9. Umkehrprozess nach Anspruch 8, dadurch gekennzeichnet, dass der Chlorkohlenwasserstoffanteil in der Gasatmosphäre aus 90 Vol.-% Trichloräthylen und aus 10 Vol.-% Dichloräthylen zusammengemischt wird.

10. Umkehrprozess nach einem der Ansprüche 7 bis 9, dadurch gekennzeichnet, dass bei einer Leistung von 300 bis 350 Watt, einem Ätzgasfluss von ungefähr 12,5 ml/Min. und einem Druck von ungefähr 0,33 mbar gearbeitet wird.

**Revendications**

1. Procédé d'inversion pour la production de masques en chrome, dans lequel, sur un substrat revêtu d'une couche de chrome (2), on dépose une couche (3) de laque photo-sensible de type positif, on l'insole à travers un masque pour insolation, on la développe et on la revêt sur toute la surface d'une couche (4) d'un matériau qui est attaqué à sec plus lentement que le chrome; dans lequel ensuite on enlève la couche de laque photosensible (3) et la couche (4) située sur elle et dans lequel enfin on attaque à sec la couche de chrome (2), étant précisé que c'est la couche (4) subsistante qui sert de masque d'attaque, caractérisé en ce que, en tant que matériau indiqué, on utilise le dioxyde de silicium; et en ce que l'on donne à la couche de dioxyde de silicium (4) une épaisseur inférieure ou égale à 10 nm.

2. Procédé d'inversion selon la revendication 1, caractérisé en ce que l'on donne à la couche de dioxyde de silicium (4) une épaisseur entre 5 et 10 nm.

3. Procédé d'inversion selon la revendication 1 ou la revendication 2, caractérisé en ce que l'on produit la couche de dioxyde de silicium (4) au moyen d'une pulvérisation cathodique ou d'une précipitation chimique à partir de la phase gazeuse.

4. Procédé d'inversion selon la revendication 3, caractérisé en ce que dans le cas de la pulvérisation cathodique, on travaille dans une atmosphère d'argon.

5. Procédé d'inversion selon la revendication 4, caractérisé en ce que l'on travaille sous une pression de travail d'environ 30 µbar, une puissance totale en haute fréquence de 0,8 kW, une tension cathodique de 2800 V, une prétension anodique de 600 V et un débit d'argon d'environ 100 ml/min.

6. Procédé d'inversion selon l'une des revendications 1 à 5, caractérisé en ce que l'on enlève la couche de laque de photogravure (3) et la couche de dioxyde de silicium (4) située sur elle au moyen d'un mélange contenant 22,5 à 23,9% en poids de constituants non volatils, constitués partiellement du sel de sodium de l'acide sulfonique d'alkylnaphtaline et d'acide sulfonique d'alkylnaphtaline libre, ainsi que les constituants volatils, constitués de 44,5% en poids de tétrachloréthylène, 37% en poids de o-dichlorobenzène, 0,8% en poids de p-dichlorobenzène et 17,6% en poids de phénol ou d'acide de Caro (acide monopersulfurique).

7. Procédé d'inversion selon l'une des revendications 1 à 6, caractérisé en ce que l'on attaque la couche de chrome (2) par attaque par plasma.

8. Procédé d'inversion selon la revendication 7, caractérisé en ce que l'attaque se fait dans une atmosphère contenant des hydrocarbures chlorés et de l'oxygène.

9. Procédé d'inversion selon la revendication 8, caractérisé en ce que l'on ajoute le constituant hydrocarbure chloré dans une atmosphère gazeuse constituée de 90% en volume de trichloréthylène et de 10% en volume de dichloréthylène.

10. Procédé d'inversion selon l'une des revendications 7 à 9, caractérisé en ce que l'on travaille sous une puissance de 300 à 350 Watt, un débit de gaz d'attaque d'environ 12,5 ml/min et une pression d'environ 0,33 mbar.

**Claims**

1. Reverse process for making chromium masks, where onto a substrate (1) coated with a chromium layer (2) a layer (3) of positive photoresist is applied, exposed through an exposure mask, developed, and blanket-coated with a layer (4) of a material which is dry-etched more slowly than chromium, where subsequently the photoresist layer (3) and layer (4) thereupon are lifted off, and finally the chromium layer (2) is dry-etched, the remaining layer (4) being used as an etch mask, characterized in that as the said material silicon dioxide is used, and the silicon dioxide layer (4) is made $\leqslant$ 10 nm thick.

2. Reverse process as claimed in claim 1, characterized in that the silicon dioxide layer (4) is between 5 and 10 nm thick.

3. Reverse process as claimed in claim 1 or 2, characterized in that the silicon dioxide layer (4) is produced through cathode sputtering or chemical vapour deposition.

4. Reverse process as claimed in claim 3, characterized in that cathode sputtering is carried out in an argon atmosphere.

5. Reverse process as claimed in claim 4, characterized in that processing takes place at an operating pressure of approximately 30 µbar, an overall radio frequency power of 0.8 kW, a cathode voltage of 2800 V, an anode bias of 600 V, and an argon flow of approximately 100 ml/min.

6. Reverse process as claimed in any one of claims 1 to 5, characterized in that the photoresist layer (3) and the silicon dioxide layer (4) thereon are lifted off by means of a mixture containing 22.5 to 23.9 percent by weight nonvolatile components which partly consist of the sodium salt of the alkylnaphthalene sulphonic acid and the free alkylnaphthalene sulphonic acid, as well as volatile components consisting of 44.5 percent by weight tetrachloroethylene, 37 percent by weight o-dichlorobenzene, 0.8 percent by weight p-dichlorobenzene, and 17.6 percent by weight phenol, or by means of Caro acid.

7. Reverse process as claimed in any one of claims 1 to 6, characterized in that the chromium layer (3) is etched by means of plasma etching.

8. Reverse process as claimed in claim 7, characterized in that etching takes place in an atmosphere containing chlorinated hydrocarbons and oxygen.

9. Reverse process as claimed in claim 8, characterized in that the chlorinated hydrocarbon part in the gas atmosphere is composed of 90 vol.-% trichloroethylene and 10 vol.-% dichloroethylene.

10. Reverse process as claimed in any one of claims 7 to 9, characterized in that processing takes place at a power of 300 to 350 Watt, an etching gas flow of approximately 12.5 ml/min. and a pressure of approximately 0.33 mbar.

FIG.1

FIG.2

FIG.3

FIG.4